Europäisches Patentamt

European Patent Office

Office européen des brevets

(19)

(11) Veröffentlichungsnummer: **0 162 136**
**B1**

(12) **EUROPÄISCHE PATENTSCHRIFT**

(45) Veröffentlichungstag der Patentschrift:
01.03.89

(51) Int. Cl.⁴: **H 03 J 5/02, H 04 B 1/26**

(21) Anmeldenummer: **84114704.4**

(22) Anmeldetag: **04.12.84**

(54) Funkgerät für eine Vielzahl von Kanälen.

(30) Priorität: **24.05.84 DE 3419340**

(43) Veröffentlichungstag der Anmeldung:
**27.11.85 Patentblatt 85/48**

(45) Bekanntmachung des Hinweises auf die Patenterteilung:
**01.03.89 Patentblatt 89/9**

(84) Benannte Vertragsstaaten:
**DE GB NL**

(56) Entgegenhaltungen:
**DE-A- 3 007 907**
**DE-A- 3 238 356**
**GB-A- 2 015 837**

**PATENTS ABSTRACTS OF JAPAN, Band 8, Nr. 111
(E-246)[1548], 24. Mai 1984; & JP-A-59 25 429 (NEC
HOME ELECTRONICS K.K.) 09-02-1984**

(73) Patentinhaber: **Licentia Patent-Verwaltungs-GmbH,
Theodor-Stern-Kai 1, D-6000 Frankfurt/Main 70 (DE)**

(72) Erfinder: **Engel, Harald, Dipl.-Ing., Fünf-Bäume-Weg 184,
D-7900 Ulm (DE)**
Erfinder: **Winkelmann, Hartwig, Dipl.-Ing., Erlenweg 18,
D-7915 Elchingen (DE)**

(74) Vertreter: **Schulze, Harald Rudolf, Dipl.-Ing. et al,
Licentia Patent-Verwaltungs-GmbH
Theodor-Stern-Kai 1, D-6000 Frankfurt/Main 70 (DE)**

ACTORUM AG

## Beschreibung

Die Erfindung betrifft ein Funkgerät nach dem Oberbegriff des Anspruchs 1. Ein solches Gerät ist beispielsweise aus der GB-A-2 015 837 bekannt.

Aus der DE-A-30 07 907 ist ein digitaler Empfänger für eine Vielzahl von Kanälen bekannt. Ein Prozessor-IC des Empfängers enthält mehrere PROM-Speicher, in denen Kanalfrequenzen, Filterkoeffizienten und Modulations- bzw. Betriebsparameter abgespeichert sind. Über eine externe Kommandierung, z.B. eine Tastatur, können die Parameter aus den Speichern in den Prozessor eingegeben werden.

In bestehenden Funknetzen gibt es eine große Anzahl von Parametern, die von Netz zu Netz unterschiedlich sind. So kann z.B. die Signalisierung digital erfolgen mit verschiedenen Übertragungsverfahren, oder analog mit Einzelton-Rufen oder mit Tonfolgen nach ZVEI oder nach CCIR oder mit Pilottönen aus 37 CTCSS-Frequenzen.

In der GB-A-2 015 837 wird ein Funkgerät für eine Vielzahl von Kanälen beschrieben, das einen digitalen Speicher aufweist, in welchem Parameter des Funkgeräts kanalspezifisch abgespeichert sind. Dabei sind ausgewählte Parameter in Merkmalsgruppen zusammengefaßt abgespeichert, wobei jeder Merkmalsgruppe eine bestimmte Adresse zugeordnet ist. Weiterhin sind Kanäle mit gleicher Konfiguration von Merkmalen zu Kanalgruppen zusammengefaßt, wobei zu jeder Kanalgruppe eine bestimmte Konfiguration der Adressen abgespeichert ist.

Die Erfindung geht aus von einem Funkgerät, das in allen diesen Netzen einsetzbar sein soll, und dessen anwendungsbezogene Merkmale wie Sende-Empfangs-Frequenzen, Sendeleistungen, Sendezeiten, Kanalraster, Modulationsarten, Rauschsperrenschwelle, Ruftöne, Tonfolgenaussendung und -auswertung usw. digital kontrolliert sind. Insbesondere bei Handsprechfunkgeräten ist es aus Kostengründen und Gründen der Raumersparnis aber nicht möglich, eine größere Anzahl digitaler Speicher einzubauen, die alle denkbaren oder wünschbaren Parameter-Variationen für z.B. 1000 Kanäle speichern könnten.

Aufgabe der Erfindung ist es, ein Funkgerät der eingangs genannten Art anzugeben, das der Anwender mit wenigen Handgriffen für die Teilnahme in unterschiedlichen Netzen einrichten kann, und welches eine möglichst große Zahl unterschiedlicher Parameter kanalspezifisch in einem einzigen Speicherbaustein abgespeichert enthält.

Die Erfindung ist im Patentanspruch 1 gekennzeichnet. Die weiteren Ansprüche enthalten vorteilhafte Weiterbildungen der Erfindung.

Die Erfindung wird im folgenden anhand der Figuren näher erläutert.

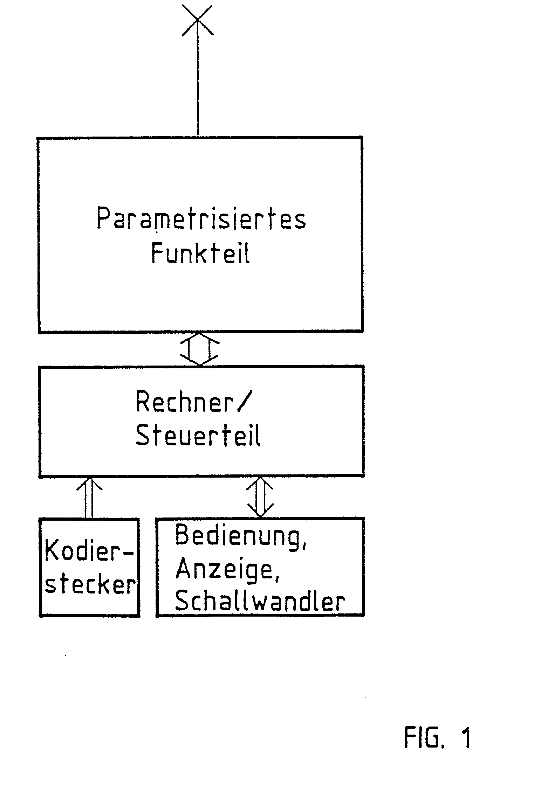

Fig. 1 zeigt ein Blockschaltbild eines erfindungsgemäßen Funkgeräts. Das Funkteil ist parametrisiert. Alle anwendungsbezogenen Merkmale sind, wie oben bereits erwähnt, digital kontrollierbar. Ein Steuerteil mit einem Mikroprozessor (Rechner) liest die in einem digitalen Speicher gespeicherten Parameter aus und steuert entsprechend das Funkteil und die Geräteperipherie. Ist der Speicher in einem von außen steckbaren Kodierstecker eingebaut, kann das Funkgerät im Handumdrehen durch einfaches Auswechseln des Kodiersteckers durch den Anwender in ein Gerät mit völlig anderen Eigenschaften verwandelt werden.

Bei einem Funkgerät mit bis zu tausend Kanälen wäre eine große Anzahl von handelsüblichen K-Byte Speichern notwendig, um für jeden Kanal einzeln alle zugehörigen Merkmale abzuspeichern. Durch die erfindungsgemäße Belegung der Speicherplätze gelingt es jedoch, auch eine große Zahl unterschiedlicher Konfigurationen in einem einzigen digitalen Speicher beschränkter Kapazität abzuspeichern.

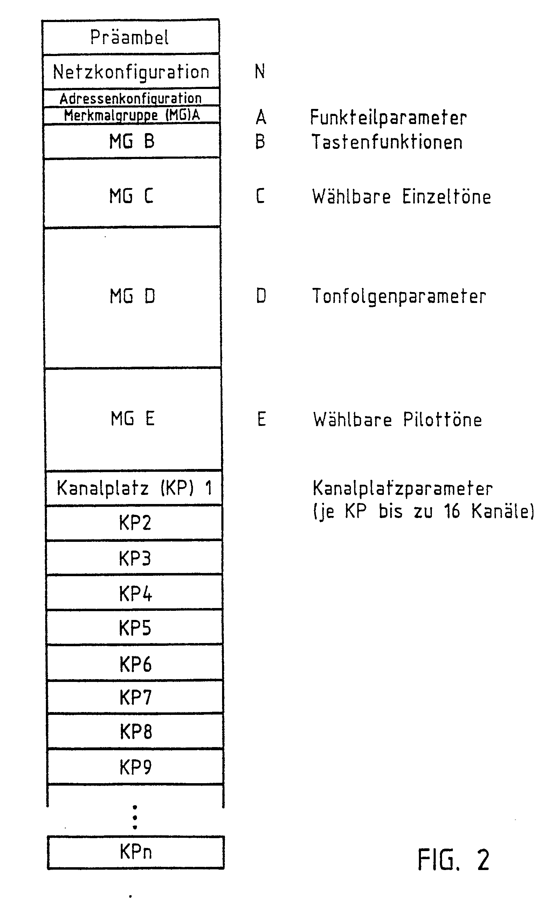

Fig. 2 zeigt im Ausführungsbeispiel ein Schema der erfindungsgemäßen Speicherplatzbelegung. Ausgewählte Parameter, die jeweils ein oder mehrere Bit bzw. Byte umfassen, sind in Merkmalgruppen MG A bis MG E zusammengefaßt abgespeichert. Merkmalgruppe A enthält z.B. Funkteilparameter wie Sendeleistung, Rauschsperrenschwelle, Kanalraster, Sendezeitbegrenzung. Merkmalgruppe B enthält die Belegung von Sprech- und Ruftasten. Merkmalgruppe C enthält z.B. wählbare Einzeltöne für die Signalisierung, Merkmalgruppe D Parameter von Tonfolgen, Merkmalgruppe E wählbare Pilottöne. Jeder Merkmalgruppe ist eine erste Adresse zugeordnet, unter der sie aufgefunden werden kann. Die Merkmalgruppen MG A bis MG E können auch mehrfach auftreten, z.B. MG A1, MG A2 usw., was in Fig. 2 nicht dargestellt ist, wenn beispielsweise unterschiedliche Sendezeitbegrenzungen für unterschiedliche Kanalgruppen festgelegt werden sollen.

Kanäle mit gleicher Konfiguration von Merkmalen sind in Kanalgruppen zusammengefaßt auf Kanalplätzen KP1 bis KPn abgespeichert. Zu jeder Kanalgruppe gehört eine Adressenkonfiguration von Merkmalgruppen. Diese Adressenkonfigurationen sind unter zweiten Adressen abgespeichert. (In Fig. 2 ist nur eine Adressenkonfiguration dargestellt.) Auf den Kanalplätzen sind jeweils die zweiten Adressen angegeben, unter denen die Adressenkonfigurationen der Kanalgruppen stehen. Auf KP1 sei beispielsweise eine Gruppe von Kanälen bezeichnet, auf denen u.a. eine Sendezeitbegrenzung besteht und bei denen die Sprech- oder Ruftasten mit festen Einzeltönen belegt sind. Die zugehörige Adressenkonfiguration wäre MG A1, MG B1. Die gleiche Adressenkonfiguration kann eine auf KP2 gespeicherte Kanalgruppe aufweisen, wobei diese Kanalgruppe eine andere Schrittweite oder einen anderen Gegensprechabstand haben kann. Auf KP3 sei eine Kanalgruppe bezeichnet, auf der keine Sendezeitbeschränkung besteht und eine Signalisierung mit wählbaren Einzeltönen erfolgt. Die zugehörige Adressenkonfiguration wäre MG A2, MG B2, MG C.

Die Wahl eines Kanals oder der wählbaren Ruftöne erfolgt mittels einer Tastatur im Bedienteil des Funkgeräts. Die weitere Verarbeitung wird vom Steuerteil übernommen.

In Fig. 2 sind noch Speicherplätze für eine Präambel und für Netzkonfigurationen vorgesehen. Erstere enthält z.B. Angaben über den Gerätetyp und die Kapazität des Kcodiersteckers. Die Netzkonfiguration gibt u.a. an, welche Kanäle in einem bestimmten Netz gewählt werden dürfen.

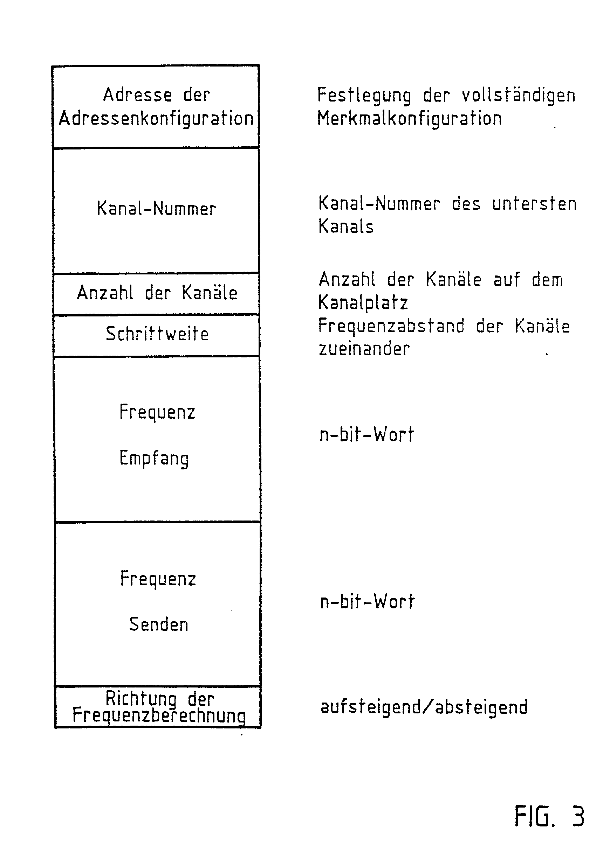

Fig. 3 zeigt die Organisation eines Kanalplatzes in vorteilhafter Weiterbildung der Erfindung. Auf einem Kanalplatz sind abgespeichert: Die zweite Adresse, unter welcher die Adressenkonfiguration zu finden ist, die Kanalnummer des untersten Kanals der Gruppe, die Anzahl der Kanäle in der Gruppe, der Kanalabstand (Schrittweite), die Empfangsfrequenz des untersten Kanals und die Sendefrequenz des untersten Kanals. Auf einem Kanalplatz zusammengefaßte Kanäle müssen also 1. die gleiche Konfiguration von Merkmalen aufweisen, 2. lückenlos aufsteigende Kanalnummern, 3. gleiche Kanalabstände, d.h. ganze Vielfache des in der dazu gehörenden MG Ax abgespeicherten Kanalrasters. Im dargestellten Ausführungsbeispiel können maximal 16 Kanäle auf einem Kanalplatz zusammengefaßt werden, weil für diese Angabe ein Speicherplatz von 4 bit vorgesehen ist.

**Patentansprüche**

1. Funkgerät für eine Vielzahl von Kanälen mit einem digitalen Speicher, in welchem Parameter des Funkgeräts kanalspezifisch abgespeichert sind, wobei ausgewählte Parameter in Merkmalsgruppen (MG A bis z.B. MG E) zusammengefaßt abgespeichert sind und jeder Merkmalsgruppe eine erste Adresse zugeordnet ist und wobei Kanäle mit gleicher Konfiguration von Merkmalen in Kanalgruppen zusammengefaßt sind und zu jeder Kanalgruppe eine Adressenkonfiguration der ersten Adressen abgespeichert ist, dadurch gekennzeichnet,
- daß der digitale Speicher in einem von außen steckbaren Kodierstecker eingebaut ist,
- daß die Kanalgruppen auf Kanalplätzen (KP1 bis KPn) abgespeichert sind,
- daß die Speicherplätze für die Adressenkonfigurationen der ersten Adressen jeweils mit einer zweiten Adresse versehen sind,
- daß auf den Kanalplätzen (KP1 bis KPn) außerdem die zweite Adresse der zur jeweiligen Kanalgruppe gehörigen Adressenkonfiguration abgespeichert ist.

2. Funkgerät nach Anspruch 1, dadurch gekennzeichnet, daß auf einem Kanalplatz (KP1 bis KPn) jeweils Kanäle mit lückenlos aufsteigenden Kanalnummern und gleichen Kanalabständen zusammengefaßt sind.

3. Funkgerät nach Anspruch 2, dadurch gekennzeichnet, daß auf einem Kanalplatz jeweils folgende Parameter abgespeichert sind: die zweite Adresse der Adressenkonfiguration, die Kanalnummer des untersten Kanals der Kanalgruppe, die Anzahl der Kanäle in der Gruppe, der Kanalabstand (Schrittweite), die Empfangsfrequenz des untersten Kanals, die Sendefrequenz des untersten Kanals (Fig. 3).

4. Funkgerät nach einem der Ansprüche 1 bis 3, dadurch gekennzeichnet, daß der digitale Speicher ein elektrisch änderbarer Speicher ist und daß die ausgewählten Parameter in diesen über die Funkgerätetastatur oder eine Funkgeräteschnittstelle eingegeben oder geändert werden können.

**Claims**

1. Radio apparatus for a multitude of channels with a digital store, in which parameters of the radio apparatus are stored specifically for the channels, wherein selected parameters are stored combined into feature groups (MG A to for example MG E) and a first address is associated with each feature group and wherein channels with like configuration of features are combined into channel groups and an address configuration of the first addresses is stored for each channel group, characterised thereby,
- that the digital store is built into a coding plug which is pluggable from outside,
- that the channel groups are stored on channel places (KP1 to KPn),
- that the storage places for the address configurations of the first addresses are each provided with a respective second address and
- that beyond that the second addresss of the address configuration belonging to the respective channel group is stored on the channel places (KP1 to KPn).

2. Radio apparatus according to claim 1, characterised thereby, that channels with gaplessly rising channel numbers and equal channel spacings are each time combined on one channel place (KP1 to KPn).

3. Radio apparatus according to claim 2, characterised thereby, that the following parameters are each time stored on one channel place: the second address of the address configuration, the channel number of the lowermost channel of the channel group, the number of channels in the group, the channel spacing (step width), the receiving frequency of the lowermost channel and the transmitting frequency of the lowermost channel (Fig. 3).

4. Radio apparatus accoding to one of the claims 1 to 3, characterised thereby, that the digital store is an electrically variable store and that the selected parameters can be put into this or altered by way of the radio apparatus keyboard or a radio apparatus interface.

**Revendications**

1. Appareil radio pour une multitude de canaux, équipé d'une mémoire numérique afin de pouvoir stocker les paramètres de l'appareil radio en fonction du canal spécifique, où certains paramètres sélectionnés sont regroupés dans cette mémoire en groupes de caractéristiques (par exemple «GdC A» jusqu'à «GdC E») dont chacun est affecté d'une première adresse, où les canaux ayant une même configuration de caractéristiques sont regroupés en groupes de canaux et où pour chacun des groupes de canaux une configuration d'adresses de ces premières adresses est mémorisée, et caractérisé en ce que

- la mémoire numérique est logée dans un connecteur avec détrompeur, enfichable de l'extérieur,
- les groupes de canaux sont mémorisés sur des places de canaux (PdC1 à PdCn),
- les places mémoire pour les configurations d'adresses des premières adresses sont chaque fois affectés d'une deuxième adresse,
- la deuxième adresse appartenant à la configuration d'adresses du groupe de canaux correspondant est mémorisée dans les places de canaux (PdC1 à PdCn).

2. Appareil radio selon revendication 1, caractérisé en ce que sur une place de canaux (PdC1 à PdCn) sont chaque fois regroupés des canaux ayant des numéros consécutifs et des intervalles inter-canal identiques.

3. Appareil radio selon revendication 2, caractérisé en ce que sur chaque place de canaux sont mémorisés les paramètres suivants: la deuxième adresse de la configuration d'adresses, le numéro du canal le plus bas du groupe, le nombre de canaux dans le groupe, l'intervalle inter-canal (distance entre deux canaux consécutifs), le fréquence de réception du canal le plus bas et la fréquence d'émission du canal le plus bas (fig. 3).

4. Appareil radio selon l'une des revendications 1 à 3, caractérisé en ce que la mémoire numérique est altérable électriquement et que les paramètres sélectionnés peuvent y être introduits ou modifiés au moyen d'un clavier ou d'une interface équipant cet appareil radio.

Parametrisiertes
Funkteil

Rechner/
Steuerteil

Kodierstecker

Bedienung,
Anzeige,
Schallwandler

FIG. 1

| | | |
|---|---|---|
| Präambel | | |
| Netzkonfiguration | N | |
| Adressenkonfiguration Merkmalgruppe (MG)A | A | Funkteilparameter |
| MG B | B | Tastenfunktionen |
| MG C | C | Wählbare Einzeltöne |
| MG D | D | Tonfolgenparameter |
| MG E | E | Wählbare Pilottöne |
| Kanalplatz (KP) 1 | | Kanalplatzparameter (je KP bis zu 16 Kanäle) |
| KP2 | | |
| KP3 | | |
| KP4 | | |
| KP5 | | |
| KP6 | | |
| KP7 | | |
| KP8 | | |
| KP9 | | |
| ⋮ | | |
| KPn | | |

FIG. 2

| | |
|---|---|
| Adresse der Adressenkonfiguration | Festlegung der vollständigen Merkmalkonfiguration |
| Kanal-Nummer | Kanal-Nummer des untersten Kanals |
| Anzahl der Kanäle | Anzahl der Kanäle auf dem Kanalplatz |
| Schrittweite | Frequenzabstand der Kanäle zueinander |
| Frequenz Empfang | n-bit-Wort |
| Frequenz Senden | n-bit-Wort |
| Richtung der Frequenzberechnung | aufsteigend/absteigend |

FIG. 3